(19) Europäisches Patentamt

European Patent Office

Office européen des brevets

(11) **EP 0 947 846 B1**

(12) **EUROPÄISCHE PATENTSCHRIFT**

(45) Veröffentlichungstag und Bekanntmachung des Hinweises auf die Patenterteilung:
**02.11.2005 Patentblatt 2005/44**

(51) Int Cl.$^7$: **G01R 33/07**

(21) Anmeldenummer: **99810214.9**

(22) Anmeldetag: **11.03.1999**

(54) **Magnetfeldsensor**

Magnetic field sensor

Capteur de champ magnétique

(84) Benannte Vertragsstaaten:
**AT CH DE ES FR GB IT LI**

(30) Priorität: **30.03.1998 CH 76098**

(43) Veröffentlichungstag der Anmeldung:
**06.10.1999 Patentblatt 1999/40**

(73) Patentinhaber: **SENTRON AG**
**6300 Zug (CH)**

(72) Erfinder: **Schott, Christian**
**1110 Morges (CH)**

(74) Vertreter: **Falk, Urs**
**Patentanwaltsbüro Dr. Urs Falk,**
**Eichholzweg 9A**
**6312 Steinhausen (CH)**

(56) Entgegenhaltungen:
**EP-A- 0 772 046          US-A- 4 123 772**
**US-A- 5 548 151**

- **PARANJAPE M ET AL: "A 3-D VERTICAL HALL MAGNETIC-FIELD SENSOR IN CMOS TECHNOLOGY*" SENSORS AND ACTUATORS A, ELSEVIER SEQUOIA S.A., LAUSANNE, CH, Bd. A34, Nr. 1, 1. Juli 1992 (1992-07-01), Seiten 9-14, XP000297419 ISSN: 0924-4247**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

Printed by Jouve, 75001 PARIS (FR)

**Beschreibung**

Die Erfindung betrifft einen Magnetfeldsensor der im Oberbegriff des Anspruchs 1 genannten Art.

Solche Magnetfeldsensoren eignen sich beispielsweise zur Verwendung in Magnetometern, die zur Messung von zwei oder von allen drei Komponenten eines Magnetfeldes ausgelegt sind.

Die Verwendung von Hallelementen als Magnetfeldsensoren ist seit langem üblich. Hallelemente, die in herkömmlicher IC-Technologie hergestellt sind, weisen alle Vorteile dieser Technologien auf, insbesondere die hohe Reproduzierbarkeit ihrer magnetischen und elektrischen Eigenschaften bei vergleichsweise geringen Kosten. Zur Messung der Komponente des Magnetfeldes, die senkrecht zur Chipoberfläche ist, werden sogenannte horizontale Hallelemente verwendet, während zur Messung der Komponenten des Magnetfeldes, die parallel zur Chipoberfläche sind, sogenannte vertikale Hallelemente verwendet werden. Vertikale Hallelemente sind elektrisch mit dem Substrat kurzgeschlossen. Es ist deshalb nicht ohne Weiteres möglich, zwei vertikale Hallelemente, die um 90° verdreht und auf dem gleichen Chip integriert sind, gleichzeitig zur Messung der beiden Komponenten $B_x$ und $B_y$ des Magnetfeldes B, die parallel zur Chipoberfläche sind, zu verwenden. Aus der wissenschaftlichen Literatur sind mehrere Magnetfeldsensoren bekannt, die auf der Struktur des vertikalen Hallelementes basieren, und die die gleichzeitige Messung der beiden Komponenten $B_x$ und $B_y$ erlauben. Diese Hallelemente weisen fünf Stromkontakte und vier Hallkontakte auf. Aus dem Artikel "A 2-D vertical Hall magnetic field sensor using active carrier confinement and micromachining techniques" von M. Paranjape, L. Landsberger und M. Kahrizi,, paper 295 - PA 12 der Konferenz Transducers 95 - Eurosensors IX) ist es bekannt, die Empfindlichkeit des Hallelementes gegen Übersprechen dadurch zu verkleinern, dass die für den Halleffekt relevanten Zonen mittels mikromechanischer Prozesse als dreidimensionale Oberflächenstrukturen ausgebildet werden. Weiter ist es aus den Artikeln "Multidimensional detection of magnetic fields using CMOS integrated sensors" von M. Paranjape und Lj. Ristic, IEEE Transactions on Magnetics, Vol. 27, No. 6, 1991 und "A 3-D vertical Hall magnetic-field sensor in CMOS technology" von M. Paranjape und I. Filanovsky, Sensors and Actuators A, 34 (1992) bekannt, durch Auftrennen der vier Hallkontakte in je zwei Hallkontakte, so dass insgesamt acht Hallkontakte vorhanden sind, einen Magnetfeldsensor zu konstruieren, der auch die Messung der zur Chipoberfläche senkrechten Komponente $B_z$ des Magnetfeldes B ermöglicht. Die Empfindlichkeit dieser Magnetfeldsensoren bezüglich der $B_z$-Komponente ist jedoch wesentlich geringer als die Empfmdlichkeit bezüglich der $B_x$- oder der $B_y$-Komponente.

Der Erfindung liegt die Aufgabe zugrunde, einen Magnetfeldsensor vorzuschlagen, der einfach herstellbar ist und der geeignet ist, wenigstens zwei, vorzugsweise alle drei Komponenten eines Magnetfeldes mit hoher örtlicher Auflösung zu messen.

Die genannte Aufgabe wird erfindungsgemäss gelöst durch die Merkmale des Anspruches 1.

Nachfolgend werden Ausführungsbeispiele der Erfindung anhand der Zeichnung näher erläutert.

Es zeigen:

Fig. 1      ein Hallelement in der Draufsicht,

Fig. 2      einen vertikalen Schnitt durch das Hallelement, das elektrisch mit dem Substrat verbunden ist,

Fig. 3      eine Schaltung zur Auswertung der Potentiale an den Spannungskontakten des Hallelementes,

Fig. 4-6      weitere Hallelemente,

Fig. 7a, b      Hallelemente, die zusätzlich mit Magnetfeldkonzentratoren versehen sind, und

Fig. 8      einen vertikalen Schnitt durch ein Hallelement, das gegenüber dem Substrat vollständig isoliert ist.

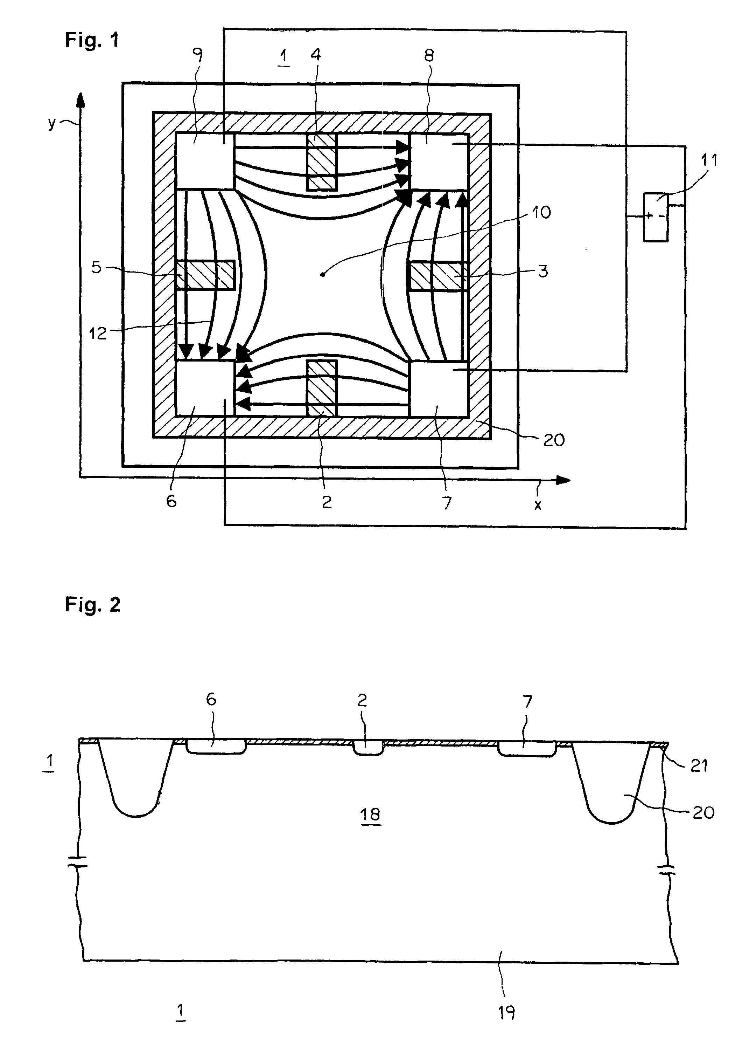

Die Fig. 1 zeigt in der Draufsicht ein Hallelement 1, das als Magnetfeldsensor zur Bestimmung der drei Komponenten $B_x$, $B_y$ und $B_z$ eines Magnetfeldes B dient. Die Komponenten $B_x$, $B_y$ und $B_z$ sind definiert bezüglich eines kartesischen Koordinatensystems mit den Achsen x, y und z. Das Hallelement 1 weist vier Spannungskontakte 2-5 und vier Stromkontakte 6-9 auf. Das Hallelement 1 ist bevorzugt quadratisch ausgebildet, wobei die vier Stromkontakte 6-9 bei den Eckpunkten des Quadrates und symmetrisch bezüglich des Mittelpunktes 10 des Quadrates angeordnet sind. Die Spannungskontakte 2-5 sind ebenfalls symmetrisch bezüglich des Mittelpunktes 10 angeordnet und befinden sich bevorzugt, aber nicht zwingend, in der geometrischen Mitte zwischen jeweils zwei der Stromkontakte 6-9. Die Stromkontakte 6 und 8 sind mit dem Pluspol einer externen Stromquelle 11, die Stromkontakte 7 und 9 sind mit dem Minuspol der Stromquelle 11 verbunden. Im Betrieb fliesst somit zwischen den Stromkontakten 6 -9 ein Strom I durch das Hallelement 1. Die lokale Stromdichte J des Stromes I ist in der Fig. 1 durch Pfeile 12 dargestellt.

Die Seiten des Quadrates sind parallel zu den x- und y-Richtungen des Koordinatensystems orientiert, während die z-Richtung senkrecht zur Zeichenebene orientiert ist. Das sich an den Spannungskontakten 2-5 einstellende elektrische Potential hängt einerseits von der Stärke des Stromes I und andererseits von den Komponenten $B_x$, $B_y$ und $B_z$ des Magnetfeldes B ab. Das Potential am Spannungskontakt 2 hängt ab von den Komponenten $+B_x$ und $+B_z$ des Magnetfeldes B, das Potential am Spannungskontakt 4 hängt ab von den Komponenten $-B_x$ und $+B_z$ des Magnetfeldes B. Dies ergibt sich daher, dass das für die Bildung der sogenannten Hallspannung verantwortliche Vektorprodukt aus dem lokalen Stromdichtefeld J beim Spannungskontakt 2 und der Komponente $B_x$ des Magnetfeldes B in die entgegengesetzte Richtung zeigt wie das Vektorprodukt aus dem lokalen Stromdichtefeld J beim Spannungskontakt 4 und der Komponente $B_x$ des Magnetfeldes B. Das Vektorprodukt aus dem lokalen Stromdichtefeld J beim Spannungskontakt 2 und der Komponente $B_z$ des Magnetfeldes B zeigt hingegen in die gleiche Richtung wie das Vektorprodukt aus dem lokalen Stromdichtefeld J beim Spannungskontakt 4 und der Komponente $B_z$ des Magnetfeldes B. Durch Addition der sich an den Spannungskontakten 2 und 4 einstellenden Potentiale ergibt sich somit ein Signal, das nur von der Komponente $B_z$ des Magnetfeldes B abhängt, während sich durch Subtraktion dieser Potentiale ein Signal ergibt, das nur von der Komponente $B_x$ des Magnetfeldes B abhängt.

Bezeichnet man mit $V_x=V(B_x)$, $V_y=V(B_y)$ und $V_z=V(B_z)$ den jeweiligen Komponenten $B_x$, $B_y$ und $B_z$ des Magnetfeldes B entsprechende Hallspannungen, dann gelten für die Potentiale $V_2$ bis $V_5$ an den Spannungskontakten 2 bis 5 die folgenden Beziehungen:

$$V_2=V_x+V_z \qquad (1)$$

$$V_3=V_y-V_z \qquad (2)$$

$$V_4=-V_x+V_z \qquad (3)$$

$$V_5=-V_y-V_z \qquad (4)$$

Durch Umformung ergibt sich:

$$V_x=\tfrac{1}{2}(V_2-V_4) \qquad (5)$$

$$V_y=\tfrac{1}{2}(V_3-V_5) \qquad (6)$$

$$V_z=\tfrac{1}{4}(V_2+V_4-V_3-V_5) \qquad (7)$$

Die Grösse $V_z$ kann auch ermittelt werden gemäss den Gleichungen

$$V_z=\tfrac{1}{2}(V_2+V_4) \qquad (8)$$

oder

$$V_z=-\tfrac{1}{2}(V_3+V_5) \qquad (9)$$

Die Gleichung (7) beinhaltet somit eine Mittelung der über die Gleichungen (8) und (9) erhaltenen Hallspannungen $V_z$.

Die Fig. 2 zeigt das Hallelement 1 in einer Schnittebene, die parallel zur x-Achse und durch die Kontakte 6, 2 und 7 verläuft. Das Hallelement 1 ist vorzugsweise als Chip in Halbleitertechnologie hergestellt. Das Hallelement 1 besteht aus einem aktiven, für die Messung der Komponenten $B_x$, $B_y$ und $B_z$ empfindlichen Gebiet 18, das aus einem relativ niedrig dotierten Halbleitermaterial eines ersten Leitfähigkeittyps besteht. Das aktive Gebiet 18 ist ein Teil des Substrates 19 des Chips. Die Stromkontakte 6-9 und die Spannungskontakte 2-5 sind hochdotierte Gebiete des ersten Leitfähigkeitstyps, die in konventioneller Weise über Leiterbahnen mit Anschlussstellen, sogenannten Pads, für die externe Kontaktierung verbunden sind. Das aktive Gebiet 18 besteht vorzugsweise aus n-leitendem Silizium, da mit der Siliziumtechnologie äusserst langzeitstabile Hallelemente hergestellt werden können. Fakultativ ist zwischen dem aktiven Gebiet 18 und der Oberfläche eine dünne Schicht 21 aus p-dotiertem Silizium vorhanden.

Das Hallelement 1 kann als Hallelement mit gegenüber dem Stand der Technik verkleinerten linearen Abmessungen hergestellt werden, da entlang der x-Richtung wie der y-Richtung jeweils nur zwei Stromkontakte und ein Spannungskontakt vorhanden sind. Bei herkömmlichen 2-D oder 3-D Hallelementen sind mindestens fünf Kontakte entlang der x- oder der y-Richtung angeordnet. Da zudem keine Gebiete eines zweiten Leitfähigkeittyps wie z.B. der weiter unten beschriebene Halbleiterring 20 (Fig. 2) nötig sind, stellt sich auch das Problem der Alignierung zwischen den hochdotierten Kontakten des ersten Leitfähigkeittyps und den Gebieten des zweiten Leitfähigkeittyps nicht, so dass der Offset der Hallspannung, d.h. die Hallspannung bei Abwesenheit des Magnetfeldes B, geringer als bei herkömmlichen Hallelementen ist.

Ein solches Hallelement 1 eignet sich als 2D- oder 3D-Magnetfeldsensor für die Messung der zu seiner Oberfläche parallelen Komponeneten $B_x$, $B_y$ bzw. aller drei Komponenten $B_x$, $B_y$ und $B_z$ des Magnetfeldes B. Die Empfindlichkeit bezüglich der Komponente $B_z$ erhöht sich jedoch markant, wenn das aktive Gebiet 18 umrandet ist von einem Halbleiterring 20 (Fig. 2) eines zweiten Leitfähigkeittyps, der eine Tiefe von typisch 10 - 30 µm aufweist. Zwischen dem aktiven Gebiet 18 und dem Halbleiterring 20 bildet sich ein isolierender P/N-Übergang, der das wirksame aktive Gebiet 18 begrenzt. Die gemessenen Empfindlichkeiten eines solchen Hallelementes 1 betragen etwa $V_x \cong V_y \cong 50$ mV/mAT und $V_z \cong 10$ mV/mAT. Sehr gering ist die Kreuzkorrelation der Empfindlichkeiten, die im Promillebereich liegt, gegenüber Werten von etwa 10% nach dem Stand der Technik.

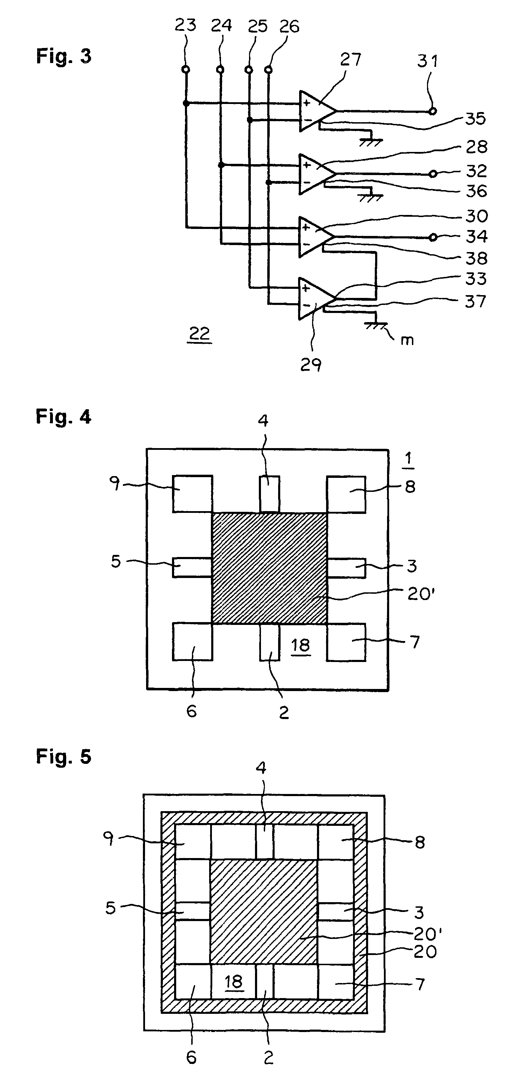

Die Fig. 3 zeigt nun eine elektronische Schaltung 22, die zur Bestimmung der Grössen $2V_x$, $2V_y$ und

$4V_z$ geeignet ist. Die Schaltung 22 weist vier Eingänge 23-26 auf, die mit Eingängen von vier Instrumentenverstärkern 27-30 verbunden sind. Geeignete Instrumentenverstärker sind im Handel beispielsweise von den Firmen Burr Brown oder Analog Devices unter der Bezeichnung "Instrumentation Amplifier" erhältlich. Jeder der Instrumentenverstärker 27-30 weist einen invertierenden und einen nicht-invertierenden Eingang sowie einen Referenzeingang auf. Dem Eingang 23 der Schaltung 22 ist die Hallspannung $V_2$, dem Eingang 24 die Hallspannung $V_3$, dem Eingang 25 die Hallspannung $V_4$ und dem Eingang 26 die Hallspannung $V_5$ zugeführt. Jeder der Instrumentenverstärker 27-30 ist intern so geschaltet, dass sein Ausgang eine Spannung $U_A$ führt, die gleich der Summe der am Referenzeingang und am nicht-invertierenden Eingang anliegenden Spannungen $U_R$ bzw. $U_+$ minus die am invertierenden Eingang anliegende Spannung $U_-$ ist: $U_A = U_R + U_+ - U_-$.

Die Referenzeingänge 35, 36, 37 des ersten, des zweiten und des dritten Instrumentenverstärkers 27 bzw. 28 bzw. 29 sind mit einem als Bezugspotential dienenden Masseanschluss m verbunden. Der Referenzeingang 38 des vierten Instrumentenverstärkers 30 ist mit dem Ausgang 33 des dritten Instrumentenverstärkers 29 verbunden. Der nicht-invertierende Eingang des ersten Instrumentenverstärkers 27 ist mit dem Eingang 23 verbunden, so dass an ihm die Hallspannung $V_2$ anliegt. Der invertierende Eingang des ersten Instrumentenverstärkers 27 ist mit dem Eingang 25 verbunden, so dass an ihm die Hallspannung $V_4$ anliegt. Sein Ausgang 31 führt daher die Spannung $U_{A1}=V_2-V_4=2V_x$. Wie der in der Figur gezeigten Verdrahtung weiter zu entnehmen ist, führen der Ausgang 32 des zweiten Instrumentenverstärkers 28 die Spannung $U_{A2}=V_3-V_5=2V_y$, der Ausgang 33 des dritten Instrumentenverstärkers 29 die Spannung $U_{A3}=V_4-V_5$ und der Ausgang 34 des vierten Instrumentenverstärkers 30 die Spannung $U_{A4} = U_{A3}+V_2-V_3 = V_2+V_4 -V_3 -V_5 = 4V_z$.

Die Gesamtempfindlichkeiten des Magnetfeldsensors, der aus dem Hallelement 1 und der elektronischen Schaltung 22 besteht, an den drei Ausgängen 31 - 33 der elektronischen Schaltung 22 betragen somit etwa $V(B_x) \cong V(B_y) \cong 100$ mV/mAT und $V(B_z) \cong 40$ mV/ mAT .

Die Spannung $V_z$ kann auch dargestellt werden als Summe der paarweisen Differenz benachbarter Spannungskontakte 2-5: $8V_z=(V_2-V_3) + (V_4-V_5) +(V_2-V_5) +(V_4-V_3)$. Die Spannung $V_z$ lässt sich auch gemäss dieser Beziehung ermitteln, wobei dann die in der Fig. 3 gezeigte Schaltung 22 um zwei weitere Instrumentenverstärker zu erweitern ist, die die Differenzen $V_2-V_5$ und $V_4-V_3$ zur Spannung am Ausgang 34 des vierten Instrumentenverstärkers 30 addieren. Eine derart erweiterte Schaltung weist den Vorteil auf, dass die Spannung $V_z$ einen Wert für die Komponente $B_z$ des Magnetfeldes B darstellt, der optimal über das durch das aktive Gebiet definierte Volumen des Magnetfeldsensors gemittelt ist.

Im folgenden sind nun weitere Hallelemente aufgeführt, die sich von den bisher beschriebenen Hallelementen hauptsächlich in der Geometrie, kaum aber in ihren elektrischen oder magnetischen Eigenschaften unterscheiden.

Die Fig. 4 zeigt ein für einen 3-D Magnetfeldsensor geeignetes Hallelement 1, bei dem das aktive Gebiet 18 und die Strom- und Spannungskontakte 6 - 9 bzw. 2 - 5 nicht von dem in den Fig. 1 und 2 gezeigten Ring 20 umrandet sind, sondern bei dem das aktive Gebiet 18 und die Strom- und Spannungskontakte 6 - 9 bzw. 2 - 5 ausserhalb eines quadratischen Gebietes 20' angeordnet sind. Das Gebiet 20' besteht wie der Ring 20 aus Halbleitermaterial, dessen Leitfähigkeitstyp entgegengesetzt zu dem des aktiven Gebietes 18 ist.

Die Fig. 5 zeigt ein Hallelement 1 mit dem quadratischen Gebietes 20' und mit dem Ring 20, bei dem also das aktive Gebiet 18 und die Strom- und Spannungskontakte 6 - 9 bzw. 2 - 5 in einem Kanal angeordnet sind, der von Gebieten des zweiten Leitfähigkeittyps begrenzt ist.

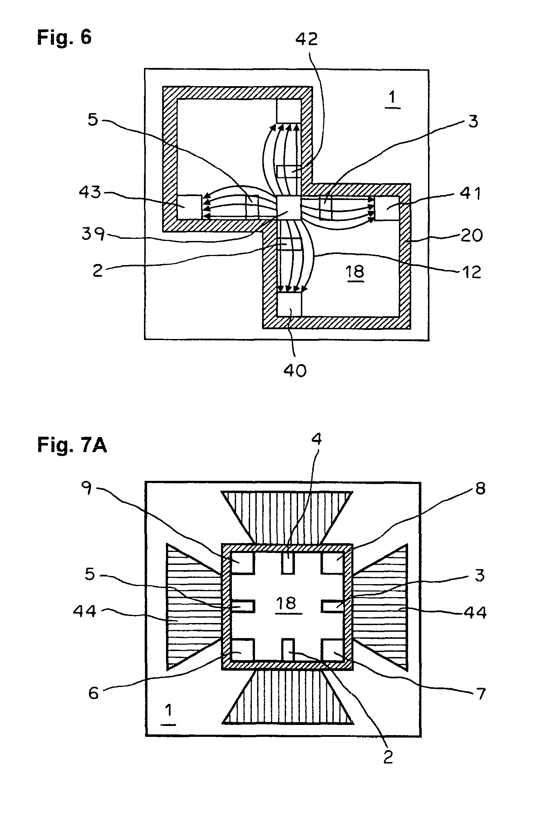

Die Fig. 6 zeigt ein Hallelement 1 mit einer kreuzförmigen Anordnung der Strom- und Spannungskontakte, wobei das aktive Gebiet 18 wie dargestellt von dem Ring 20 umschlossen ist. Dieses Hallelement 1 weist einen einzigen zentralen Stromkontakt 39, der mit dem einen Pol der Stromquelle verbunden ist, und vier Stromkontakte 40 - 43 auf, die mit dem anderen Pol der Stromquelle verbunden sind. Die vier Stromkontakte 40 - 43 und die Spannungskontakte 2 - 5 sind symmetrisch bezüglich des zentralen Stromkontaktes 39 angeordnet. Es ist nicht erforderlich, die Spannungskontakte 2 - 5 geometrisch in der Mitte zwischen dem zentralen Stromkontakt 39 und den entsprechenden äusseren Stromkontakten 40 - 43 anzuordnen.

Es sind natürlich auch andere Geometrien des Hallelementes 1 verwirklichbar. Aus der US-amerikanischen Patentschrift US 5 057 890 ist es bekannt, dass Hallelemente invariant unter konformen Abbildungen sind und daher beliebige geometrische Formen aufweisen können. Ebenfalls kann die Lage der Spannungskontakte gegenüber der Lage der Stromkontakte verschoben werden, insoweit die Verschiebungen nicht dazu führen, dass die Hallspannungen $V_x$, $V_y$ und $V_z$ verändert werden.

Der Halbleiterring 20 (Fig. 2) kann entweder frei floaten, oder er kann mit dem Minuspol der Stromquelle 11 (Fig. 1) verbunden sein oder er kann auf ein gegenüber den Polen der Stromquelle 11 vordefiniertes Potential gesetzt werden, wobei darauf zu achten ist, dass der P/N-Übergang immer in Sperrrichtung gepolt ist.

Ein Hallelement 1, das nur die das aktive Gebiet 18 kontaktierenden Strom- und Spannungskontakte 6-9 bzw. 2-5 und ev. die dünne Schicht 21 aufweist, das also weder seitlich von einem Gebiet des zweiten Leitfähigkeittyps begrenzt ist noch ein solches begrenzt, eignet sich in Verbindung mit Magnetfeldkonzentratoren sehr gut als 2-D Magnetfeldsensor zur Messung der parallel zu seiner Oberfläche gerichteten Komponenten $B_x$ und $B_y$ des Magnetfeldes B.

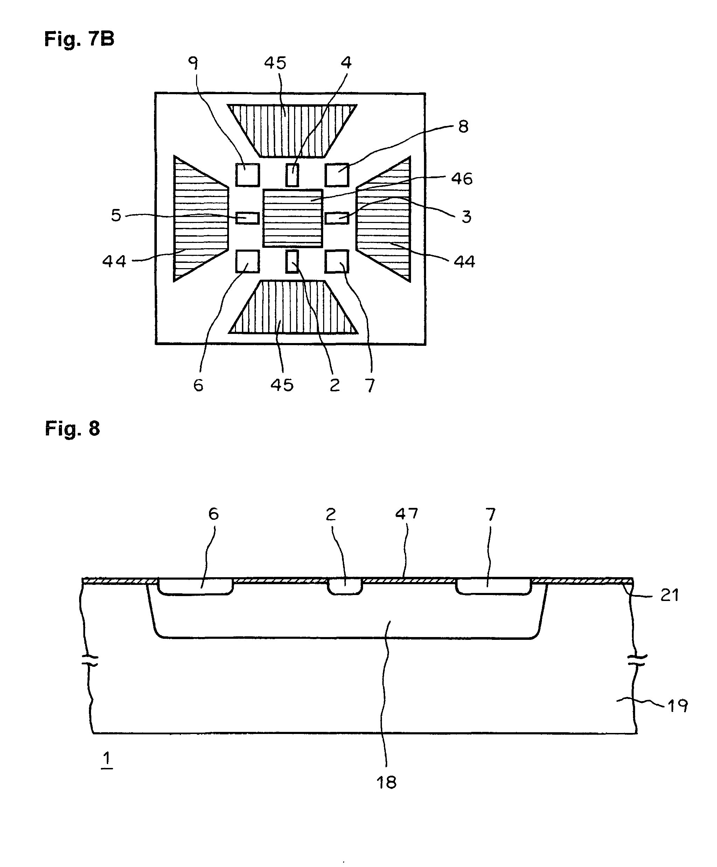

Die Fig. 7a und 7b zeigen in der Draufsicht solche Magnetfeldsensoren. Auf der Oberfläche des Hallelementes 1 sind vorzugsweise trapezförmig ausgebildete Magnetfeldkonzentratoren 44, 45 angeordnet. Die Magnetfeldkonzentratoren 44 verstärken die Komponente $B_x$, die Magnetfeldkonzentratoren 45 verstärken die Komponente $B_y$ des Magnetfeldes B im Bereich der entsprechenden Hallkontakte und erhöhen somit die Empfindlichkeit des Magnetfeldsensors für die Komponenten $B_x$ und $B_y$. Bei dem Ausführungsbeispiel nach Fig. 7b befindet sich auch in der Mitte des Hallelementes 1 ein Magnetfeldkonzentrator 46. Die Magnetfeldkonzentratoren 44, 45, 46 bestehen aus ferromagnetischem Material, z.B. aus Mumetall oder Permalloy. Das in der Fig. 7a dargestellte, das aktive Gebiet 18 begrenzende Gebiet 20 des zweiten Leitfähigkeittyps kann vorhanden oder weggelassen sein.

Die offenbarten Magnetfeldsensoren weisen insgesamt folgende Vorteile auf:

a) Die Messung der drei Komponenten $B_x$, $B_y$ und $B_z$ des Magnetfeldes B erfolgt in einem gemeinsamen Volumen bzw. Punkt (gemeinsames aktives Gebiet 18).
b) Vergleichbare Empfindlichkeiten aller drei Komponenten $B_x$, $B_y$ und $B_z$ des Magnetfeldes bei sehr geringer Kreuzkorrelation.
c) Die Spannungen $V_x$, $V_y$ und $V_z$ zeichnen sich durch hohe Linearität bezüglich des Magnetfeldes B aus.
d) Die Anzahl der benötigten elektrischen Anschlüsse ist beschränkt auf 6.
e) Das aktive Gebiet 18 umfasst eine kleine Fläche, die typischerweise nur 100 μm * 100 μm bis 300 μm * 300 μm beträgt.
f) Hohe Langzeitstabilität, da die Magnetfeldsensoren in der bewährten Siliziumtechnologie herstellbar sind. sind.

Die Fig. 8 zeigt im Schnitt das Hallelement 1 in einer Ausführung, bei dem das aktive Gebiet 18 elektrisch vom Substrat 19 isoliert ist. Das Substrat 19 besteht vorzugsweise aus p-leitendem Material, das das aus n-leitendem Material bestehende aktive Gebiet 18 auf allen Seiten, ev. mit Ausnahme der Oberfläche 47, vollständig umschliesst.

**Patentansprüche**

1. Magnetfeldsensor zur Messung der drei Komponenten $B_x$, $B_y$, $B_z$ eines Magnetfeldes, der ein Hallelement (1) und eine elektronische Schaltung (22) aufweist, wobei das Hallelement (1) ein aktives Gebiet (18) eines ersten Leitfähigkeittyps aufweist, das mit Spannungs- und Stromkontakten (2-5 bzw. 6-9; 2-5 bzw. 39-42) kontaktiert ist, **dadurch gekennzeichnet, dass** vier Spannungskontakte (2-5) vorhanden sind, die mit der elektronischen Schaltung (22) verbunden sind, die aus den an den Spannungskontakten (2-5) anliegenden elektrischen Potentialen $V_2$, $V_3$, $V_4$, $V_5$ durch Summen- bzw. Differenzbildung drei Signale $V_x$, $V_y$, $V_z$ ableitet, die proportional zu den drei Komponenten $B_x$, $B_y$, $B_z$ des Magnetfeldes sind.

2. Magnetfeldsensor nach Anspruch 1, **dadurch gekennzeichnet, dass** das aktive Gebiet (18) weder seitlich durch ein Gebiet (20) eines zweiten Leitfähigkeittyps begrenzt ist noch seinerseits ein Gebiet (20') eines zweiten Leitfähigkeittyps seitlich begrenzt.

3. Magnetfeldsensor nach Anspruch 1, **dadurch gekennzeichnet, dass** das aktive Gebiet (18) seitlich durch ein Gebiet (20) eines zweiten Leitfähigkeittyps begrenzt ist und/oder ein Gebiet (20') eines zweiten Leitfähigkeittyps seitlich begrenzt.

4. Magnetfeldsensor nach einem der Ansprüche 1 bis 3, **dadurch gekennzeichnet, dass** Magnetfeldkonzentratoren (44, 45; 44, 45, 46) vorhanden sind, die die parallel zur Oberfläche des Hallelementes (1) gerichteten Komponenten $B_x$, $B_y$ des Magnetfeldes im Bereich der entsprechenden Spannungskontakte (2, 4 bzw. 3, 5) verstärken.

5. Magnetfeldsensor nach einem der Ansprüche 1 bis 4, **dadurch gekennzeichnet, dass** die elektronische Schaltung (22) wenigstens eines der Signale $V_x$, $V_y$, $V_z$ mittels Instrumentenverstärkern (29, 30) bildet.

6. Magnetfeldsensor nach einem der Ansprüche 1 bis 5, **dadurch gekennzeichnet, dass** entlang einer beliebigen Richtung höchstens drei Strom- und/oder Spannungskontakte angeordnet sind.

**Claims**

1. Magnetic field sensor for the measurement of the three components $B_x$, $B_y$, $B_z$ of a magnetic field, comprising a Hall-effect element (1) and an electronic circuit (22) whereby the Hall-effect element (1) has an active area (18) of a first conductivity type which is contacted with voltage and current contacts (2-5 or 6-9; 2-5 or 39-42), **characterised in that** four voltage contacts (2-5) are present that are connected to the electronic circuit (22) which derives three signals $V_x$, $V_y$, $V_z$ by means of summation or differential formation of the electrical potentials $V_2$, $V_3$, $V_4$, $V_5$ present at the voltage contacts (2-5) which are proportional to the three components $B_x$, $B_y$, $B_z$ of the magnetic field.

**2.** Magnetic field sensor according to claim 1, **characterised in that** the active area (18) is neither laterally limited by an area (20) of a second conductivity type nor itself laterally limits an area (20') of a second conductivity type.

**3.** Magnetic field sensor according to claim 1, **characterised in that** the active area (18) is laterally limited by an area (20) of a second conductivity type and/or laterally limits an area (20') of a second conductivity type.

**4.** Magnetic field sensor according to any of claims 1 to 3, **characterised in that** magnetic field concentrators (44, 45; 44, 45, 46) are present which amplify the components $B_x$, $B_y$ of the magnetic field directed parallel to the surface of the Hall-effect element (1) in the area of the corresponding voltage contacts (2, 4 or 3, 5).

**5.** Magnetic field sensor according to any of claims 1 to 4, **characterised in that** the electronic circuit (22) forms at least one of the signals $V_x$, $V_y$, $V_z$ by means of instrumentation amplifiers (29, 30).

**6.** Magnetic field sensor according to any of claims 1 to 5, **characterised in that** a maximum of three current and/or voltage contacts are arranged along any direction.

## Revendications

**1.** Capteur de champ magnétique pour la mesure des trois composants $B_x$, $B_y$, $B_z$ d'un champ magnétique qui comprend un élément Hall (1) et un circuit électronique (22); l'élément Hall (1) comprenant une zone active (18) d'un premier type de conductivité qui est en contact avec des contacts de tension et de courant (2-5 respectivement 6-9; 2-5 respectivement 39-42), **caractérisé en ce qu'il** existent quatre contacts de tension qui sont connectés au circuit électronique (22) qui déduit trois signaux $V_x$, $V_y$, $V_z$ à partir des potentiels électriques $V_2$, $V_3$, $V_4$, $V_5$ présents sur les contacts de tension (2-5) par la formation de sommes respectivement de différences, lesquels signaux sont proportionnels aux trois composants $B_x$, $B_y$, $B_z$ du champ magnétique.

**2.** Capteur de champ magnétique selon la revendication 1, **caractérisé en ce que** la zone active (18) n'est pas limitée latéralement par une zone (20) d'un second type de conductivité et ne limite pas latéralement de son côté, une zone (20') d'un second type de conductivité.

**3.** Capteur de champ magnétique selon la revendication 1, **caractérisé en ce que** la zone active (18) est limitée latéralement par une zone (20) d'un second type de conductivité et/ou limite latéralement une zone (20') d'un second type de conductivité.

**4.** Capteur de champ magnétique selon une des revendications 1 à 3, **caractérisé en ce qu'il** existe des concentrateurs de champ magnétique (44, 45; 44, 45, 46) qui renforcent les composants $B_x$, $B_y$ du champ magnétique orientés de façon parallèle par rapport à la surface de l'élément Hall (1) dans la zone des contacts de tension (2, 4 respectivement 3, 5) correspondants.

**5.** Capteur de champ magnétique selon une des revendications 1 à 4, **caractérisé en ce que** le circuit électronique (22) forme au moins un des signaux $V_x$, $V_y$, $V_z$ au moyen d'amplificateurs d'instrument (29, 30).

**6.** Capteur de champ magnétique selon une des revendications 1 à 5, **caractérisé en ce qu'au** maximum trois contacts de courant et/ou de tension sont disposés le long d'une direction quelconque.

**Fig. 1**

**Fig. 2**

**Fig. 3**

**Fig. 4**

**Fig. 5**

8

Fig. 6

Fig. 7A

**Fig. 7B**

**Fig. 8**